(19) Europäisches Patentamt
European Patent Office
Office européen des brevets

(11) EP 1 358 492 B1

(12) # EUROPÄISCHE PATENTSCHRIFT

(45) Veröffentlichungstag und Bekanntmachung des Hinweises auf die Patenterteilung:
**06.07.2005 Patentblatt 2005/27**

(21) Anmeldenummer: **02709953.0**

(22) Anmeldetag: **05.02.2002**

(51) Int Cl.$^7$: **G01R 15/24**

(86) Internationale Anmeldenummer:
**PCT/CH2002/000068**

(87) Internationale Veröffentlichungsnummer:
**WO 2002/063317 (15.08.2002 Gazette 2002/33)**

(54) **VERFAHREN ZUR TEMPERATURKOMPENSIERTEN ELEKTRO-OPTISCHEN MESSUNG EINER ELEKTRISCHEN SPANNUNG UND VORRICHTUNG ZUR DURCHFÜHRUNG DES VERFAHRENS**

METHOD FOR THE TEMPERATURE-COMPENSATED, ELECTRO-OPTICAL MEASUREMENT OF AN ELECTRICAL VOLTAGE AND DEVICE FOR CARRYING OUT THE METHOD

PROCEDE DE MESURE ELECTO-OPTIQUE D'UNE TENSION ELECTRIQUE AVEC COMPENSATION DE TEMPERATURE, ET DISPOSITIF POUR LA MISE EN OEUVRE DE CE PROCEDE

(84) Benannte Vertragsstaaten:
**AT BE CH CY DE DK ES FI FR GB GR IE IT LI LU MC NL PT SE TR**

(30) Priorität: **06.02.2001 EP 01810120**

(43) Veröffentlichungstag der Anmeldung:
**05.11.2003 Patentblatt 2003/45**

(73) Patentinhaber: **ABB RESEARCH LTD.**
**8050 Zürich (CH)**

(72) Erfinder:
- **STANIMIROV, Michael**
  **CH-5400 Baden (CH)**
- **BOHNERT, Klaus**
  **CH-5452 Oberrohrdorf (CH)**

(74) Vertreter: **ABB Patent Attorneys**
**c/o ABB Schweiz AG,**
**Intellectual Property (CH-LC/IP),**
**Brown Boveri Strasse 6**
**5400 Baden (CH)**

(56) Entgegenhaltungen:
**EP-A- 0 729 033**
**US-A- 4 629 323**
**US-A- 5 895 912**

- **FILIPPOV V N ET AL: "FIBER SENSOR FOR SIMULTANEOUS MEASUREMENT OF VOLTAGE AND TEMPERATURE" IEEE PHOTONICS TECHNOLOGY LETTERS, IEEE INC. NEW YORK, US, Bd. 12, Nr. 11, November 2000 (2000-11), Seiten 1543-1545, XP000981087 ISSN: 1041-1135**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 358 492 B1

Printed by Jouve, 75001 PARIS (FR)

## Beschreibung

Technisches Gebiet

Die Erfindung betrifft ein Verfahren zur Messung einer elektrischen Spannung mit einem elektro-optischen Medium gemäss Oberbegriff von Anspruch 1 sowie eine Vorrichtung zur Messung einer elektrischen Spannung gemäss Oberbegriff von Anspruch 5.

Stand der Technik

Ein elektro-optisches Medium ist ein Material, dessen Brechungsindex bzw. dessen Lichtausbreitungsgeschwindigkeit sich für mindestens eine Lichtpolarisation ändert, wenn ein elektrisches Feld angelegt: wird.

Die Messung elektrischer Spannungen mittels elektro-optischer Medien ist bekannt. Ein entsprechendes Gerät wird z.B. in US 4 904 931 offenbart. Es enthält einen elektro-optischen Kristall zwischen zwei Polarisatoren. Durch den Pockels-Effekt wird im Kristall eine Änderung der Brechungsindizes erzeugt, die zu einer Modulation der Lichtintensität nach dem zweiten Polarisator führt. Diese Modulation ist periodisch von der Spannung abhängig. Um ein eindeutiges Messresultat zu erhalten, werden in US 4 904 931 deshalb zwei Strahlen gleicher Wellenlänge durch den Kristall geführt.

US 4 531 092 beschreibt ein Verfahren zur Messung einer elektrischen Spannung, bei welchem zwei Strahlen unterschiedlicher Wellenlänge durch einen elektro-optischen Kristall geschickt werden. Dabei wird nur einer der beiden Strahlen ausgangsseitig polarisiert, so dass die Intensität des zweiten Strahls nicht von der Spannung abhängig ist. Diese Massnahme erlaubt es, den zweiten Strahl als Referenzgrösse zu verwenden und die Genauigkeit der Messung zu verbessern.

US 5,895,912 offenbart ein Verfahren zur Messung einer elektrischen Spannung mittels eines elektrooptischen Mediums, wobei Licht nur einer Wellenlänge durch das Medium geschickt wird. Eine Kompensation von Temperatur-Einflüssen wird mittels einer als bekannt vorausgesetzten Temperatur T und mittels Signal-Normierung und Fit-Funktionen erzielt.

US 4,629,323 offenbart eine Messvorrichtung zur Messung einer elektrischen Spannung mittels eines elektrooptischen Mediums, wobei polarisierte Lichtwellen zweier Frequenzen $\nu_1$, $\nu_2$ und unterschiedlicher Polarisation durch das Medium geschickt werden. Das Mess-Signal wird in ein elektrisches Signal der Frequenz $|\nu_1-\nu_2|$ umgewandelt, welches entsprechend einer Phasendifferenz phasenmoduliert ist, die die Lichtwellen in dem elektrooptischen Medium erfahren. Es wird keine explizite Methode zur Korrektur eines gefundenen Spannungswertes mittels eines gemessenen Temperatur-Wertes offenbart.

EP 0 729 033 A2 offenbart eine Vorrichtung zur Messung eines elektrischen Stromes mittels eines magnetooptischen Mediums, wobei zwei Lichtstrahlen gleicher Wellenlänge das Medium in entgegengesetzter Richtung durchlaufen. Vor und hinter dem Medium befinden sich Polarisatoren, durch welche die Lichtwellen polarisiert werden. Nach Durchlaufen des jeweils zweiten Polarisators werden die Lichtwellen detektiert. Aufgrund der Nicht-Reziprozität des Faraday-Effekts kann der Einfluss der Temperatur auf ein derart gemessenes Signal von dem Einfluss des zu messenden elektrischen Stromes getrennt werden.

In V.N. Filippov et al., "*Fiber Sensor for Simultaneous Measurement of Voltage and Temperature*", IEEE Photonics Tech. Lett. 12, 11 (2000) ist ein kombinierter Temperatur- und Spannungssensor und ein entsprechendes Verfahren offenbart. Die Spannungsmessung erfolgt mittels eines elektrooptisch aktiven Kristalls unter Einsatz von zwei polarisierten Lichtstrahlen unterschiedlicher Wellenlänge. Eine $\lambda$/4-Platte, die zur Erzeugung der Polarisation dient, dient als ein temperaturempfindliches Element, mittels dessen über ein Gleichungssystem die Temperatur und die Spannung bestimmt wird.

Der in der genannten Schrift von V.N. Filippov et al. offenbarte Sensor bildet den Oberbegriff des Patentanspruchs 1. Das ebenda offenbarte Verfahren bildet den Oberbegriff des Patentanspruchs 5.

Bei Verfahren der oben erwähnten Art muss der effektive elektro-optische Koeffizient genau bekannt sein. Da dieser Koeffizient in der Regel temperaturabhängig ist, kann es zu Ungenauigkeiten kommen.

Darstellung der Erfindung

Es stellt sich die Aufgabe, ein Verfahren der eingangs genannten Art sowie eine entsprechende Vorrichtung bereitzustellen, wodurch in einfacher Weise temperaturabhängige Schwankungen kompensierbar sind.

Diese Aufgabe wird vom Verfahren gemäss Anspruch 1 und der Vorrichtung gemäss Anspruch 8 gelöst.

Erfindungsgemäss wird das elektro-optische Medium also von zwei Lichtstrahlen unterschiedlicher Wellenlänge durchsetzt, wobei die Signale $A_1$, $A_2$ beider Lichtstrahlen nach dem Ausgarigspolarisator gemessen werden. Diese Signale $A_1$, $A_2$ sind Funktionen $f_1$, $f_2$ der zu messenden elektrischen Spannung $V$ und der Temperatur $T$. Erfindungsgemäss werden diejenigen Werte der Temperatur *T* und der Spannung *V* gesucht werden, die das Gleichungssystem

$$A_1 = f_1(T, V)$$

und

$$A_2 = f_2(T, V)$$

lösen. Somit wird die zusätzliche Information, die aus der Messung bei einer zweiten Wellenlänge resultiert, für die Bestimmung von T und damit zur Elimination der Temperaturabhängigkeit verwendet.

Die erfindungsgemässe Vorrichtung weist einen Analysator (Polarisator) auf, der einen zweiten der zwei Lichtstrahlen polarisiert, sowie ein Mittel zur Bestimmung derjenigen Werte der Temperatur T und der elektrischen Spannung V, die das obige Gleichungssystem lösen.

Kurze Beschreibung der Zeichnung

Weitere Ausgestaltungen, Vorteile und Anwendungen der Erfindung ergeben sich aus den abhängigen Ansprüchen und aus der nun folgenden Beschreibung anhand der Figur. Dabei zeigt:

Fig. 1 eine schematische Darstellung eines zur Durchführung der Erfindung geeigneten Spannungswandlers.

Wege zur Ausführung der Erfindung

In Fig. 1 ist eine schematische Darstellung eines quaderförmigen BGO-Kristalls 1 zu erkennen, der an seinen beiden Stirnseiten mit einer Beschichtung aus einem elektrisch leitfähigen, lichtdurchlässigen Material zur Bildung von zwei Elektroden 2, 3 versehen ist. Die eine Elektrode 2 dient als Erdpotential-Anschluss 4 und die andere Elektrode 3 ist als Hochspannungspotential-Anschluss 5 vorgesehen. Die zwischen den Elektroden 2, 3 angelegte Spannung ist mit *V* bezeichnet. Auf der die Elektrode 3 bildenden Stirnseite des BGO-Kristalls 1 ist ein Umlenkprisma 6 angeordnet, während sich an der die Elektrode 2 bildenden Stirnseite des BGO-Kristalls 1 zwei lineare Polarisatoren (bzw. Analysatoren) 9 bzw. 10 befinden, an welche sich Kollimatoren 7 bzw. 8 anschliessen.

Die Polarisatoren 9, 10 sind unter 45° zu den Achsen des Kristalls orientiert. Sie können zueinander parallel oder um 90° gekreuzt sein.

In den Kollimator 7 werden zwei Lichtstrahlen 11 unterschiedlicher Wellenlängen $\lambda_1$, $\lambda_2$ eingekoppelt, welche in einer Lichterzeugungseinheit 13 erzeugt werden. Sie durchlaufen den Polarisator 9. Sie treten polarisiert durch die Elektrode 2, in den BGO-Kristall 1 und durch die Elektrode 3, werden an den Grenzflächen des Umlenkprismas 6 reflektiert und durchlaufen anschliessend die Elektrode 3, den BGO-Kristall 1, die Elektrode 2, den als Analysator 10 dienenden Polarisator und den Kollimator 8. Die ausgekoppelten Lichtstrahlen sind mit Ziffer 12 bezeichnet. Sie werden innerhalb einer Detektions-Auswerte-Einheit 15 in einem Strahlteiler 14 separiert, und ihre Signale werden in der Detektions-Auswerte-Einheit 15 einzeln erfasst und ausgewertet. Zur Auswertung der Signale beinhaltet die Detektions-Auswerte-Einheit 15 ein Auswertemittel 16. In dem Auswertemittel 16 werden also diejenigen Werte der Temperatur T und der elektrischen Spannung V bestimmt, die das Gleichungssystem $A_1 = f_1(T, V)$ und $A_2 = f_2(T, V)$ lösen.

Sind die Polarisatoren parallel, so gilt bei Lichtausbreitung entlang der optischen Achse *z* für die Signalstärke (Ausgangsleistung) $A_i = A(\lambda_i)$ jedes Lichtstrahls $i$ = 1,2 nach dem Analysator 10

$$A_i = A_{0,i} \cdot \cos^2\left(\frac{\pi}{2} \cdot \frac{V}{V_h}\right), \qquad (1)$$

wobei $A_0,i$ die Signalamplitude des Lichtstrahls $i$ und $V_h$ die Halbwellenspannung für die vorliegende Konfiguration ist. Dabei ist selbstverständlich $V_h = V_h(\lambda_i)$ die Halbwellenspannung bei der Wellenlänge $\lambda_i$ zu nehmen. Im vorliegenden Fall wird das elektrische Feld in z-Richtung des Kristalls angelegt und es gilt für die Halbwellenspannung $V_h$

$$V_h(\lambda) = \frac{\lambda}{2 \cdot r_{63}(\lambda) \cdot n^3(\lambda)}, \tag{2}$$

wobei $r_{63}$ der bei der vorliegenden Konfiguration effektive elektro-optische Koeffizient des Materials, $\lambda$ die Lichtwellenlänge des jeweiligen Lichtstrahls und $n$ der Brechungsindex des Kristalls in x- bzw. y-Richtung ist.

Sind die Polarisatoren um 90° zueinander verdreht, so gilt anstelle von Gleichung (1)

$$A_i = A_{0,i} \cdot \sin^2\left(\frac{\pi}{2} \cdot \frac{V}{V_h(\lambda_i)}\right), \tag{1'}$$

In einer bevorzugten Ausführung wird zusätzlich zwischen dem Kristall und dem Ausgangspolarisator (Analysator) (oder zwischen dem Eingangspolarisator und dem Kristall) eine Phasenverzögerungsplatte mit einer Verzögerung und Orientierung derart eingefügt, dass ohne angelegte Spannung der Phasenunterschied der beiden orthogonalen Polarisationen am Ausgangspolarisator 90° beträgt. Die Signalstärke $A_i$ ist in diesem Fall gegeben durch

$$A_i = A_{0,i} \cdot \sin^2\left(\frac{\pi}{2} \cdot \frac{V}{V_h(\lambda_i)} - \frac{\pi}{4}\right), \tag{1*}$$

Damit die Phasenverzögerungsplatte bei beiden Wellenlängen eine Verzögerung von 90° erzeugt, ist eine Platte höherer Ordnung zu verwenden. Der Vorteil der Verwendung einer zusätzlichen Phasenverzögerungsplatte liegt darin, dass zwischen positiven und negativen Spannungen unterschieden werden kann.

In vielen gängigen elektro-optischen Medien hängen die elektro-optischen Koeffizienten $r$ relativ stark von der Temperatur $T$ ab, d.h. es existiert eine im Allgemeinen bekannte Temperaturabhängigkeit

$$r = r(T). \tag{3}$$

Dabei steht der Wert $r$ für den bei der jeweiligen Konfiguration, Kristallsymmetrie und Wellenlänge wirksamen effektiven elektro-optischen Koeffizienten. Im obigen Beispiel ist $r = r_{63}$. Selbstverständlich hängt $r$ und auch $r(T)$ im allgemeinen auch von der Wellenlänge ab.

Die Gleichungen (1), (1') bzw. (1*) lassen sich, unter Berücksichtigung der Temperaturabhängigkeit, für zwei Lichtstrahlen verallgemeinert wie folgt schreiben:

$$A_1 = f_1(V, T) \tag{4a}$$

und

$$A_2 = f_2\,(V, T), \tag{4b}$$

wobei z.B. im Falle gekreuzter Polarisatoren 9, 10 die Funktionen $f_i$ gegeben sind durch

$$f_i(V,T) = A_{0,i} \cdot \sin^2\left(\frac{\pi}{2} \cdot \frac{V}{V_h(\lambda_i, T)}\right). \tag{5}$$

Für den Fall paralleler Polarisatoren ist der Sinus durch den Kosinus zu ersetzen.

In linearer Näherung gilt für die Temperaturabhängigkeit von $r$ z.B.

$$r(\lambda_i, T) = r(\lambda_i, T_0) + K_i' \cdot \Delta T, \qquad (6)$$

wobei $r(\lambda_i, T_0)$ der als bekannt vorausgesetzte elektro-optische Koeffizient bei einer Referenztemperatur To und einer Wellenlänge $\lambda_i$, $K_i'$ ein bekannter Temperaturkoeffizient bei einer Wellenlänge $\lambda_i$ und $\Delta T = T - T_0$ ist. Der genaue Temperaturwert $T$ des elektro-optischen Mediums ist in der Regel nicht bekannt.

Für das obige Beispiel wird Gleichungssystem (4) im Fall gemäss Gleichung (1`) zu

$$\begin{aligned} A_1(V,T) &= \frac{A_{0,1}}{2} \cdot \left[1 - \cos\left(2\pi \cdot \frac{n^3(\lambda_1, T_0) \cdot (r_{63}(\lambda_1, T_0) + K_1' \cdot \Delta T)}{\lambda_1} \cdot V\right)\right] \\ A_2(V,T) &= \frac{A_{0,2}}{2} \cdot \left[1 - \cos\left(2\pi \cdot \frac{n^3(\lambda_2, T_0) \cdot (r_{63}(\lambda_2, T_0) + K_2' \cdot \Delta T)}{\lambda_2} \cdot V\right)\right] \end{aligned} \qquad (7)$$

Der unbekannte Parameter $\Delta T$ und somit die Temperatur $T$ bzw. der elektro-optische Koeffizient $r_{63}(T)$ kann aus Gleichungssystem (7) berechnet werden. Es gilt:

$$\begin{aligned} \Delta T &= \frac{af - ce}{de - bf} \; mit \\ a &= 2\pi \cdot n^3(\lambda_1, T_0) \cdot r_{63}(\lambda_1, T_0)/\lambda_1 \\ b &= 2\pi \cdot n^3(\lambda_1, T_0) \cdot K_1'/\lambda_1 \\ c &= 2\pi \cdot n^3(\lambda_2, T_0) \cdot r_{63}(\lambda_2, T_0)/\lambda_2 \\ d &= 2\pi \cdot n^3(\lambda_2, T_0) \cdot K_2'/\lambda_2 \\ e &= \arccos\left(1 - \frac{2A_1}{A_{0,1}}\right) \\ f &= \arccos\left(1 - \frac{2A_2}{A_{0,2}}\right) \end{aligned} \qquad (8)$$

Ist $\Delta T$ einmal bekannt, so kann die Spannung $V$ aus einer der Gleichungen (7) direkt berechnet werden. Es gilt

$$V = \arccos\left(1 - \frac{2 \cdot A_i}{A_{0,i}}\right) \cdot \frac{\lambda_i}{2\pi \cdot n^3(\lambda_i, T_0) \cdot (r_{63}(\lambda_i, T_0) + K_i' \cdot \Delta T)}. \qquad (9)$$

Für $V \leq V_h(\lambda_i)$ hat Gleichung (9) eine eindeutige Lösung. Für $V > V_h(\lambda_i)$ ist diejenige Lösung zu suchen, die beide Gleichungen (4) (bzw. (9) für $i$ = 1 und 2) löst.

Grundsätzlich kann die Temperaturkorrektur des elektro-optischen Koeffizienten gemäss Gleichung (8) und (6) mit wesentlich geringerer Rate erfolgen als die eigentliche Messung der Spannung $V$. Es ist auch möglich, die Temperatur nur zu bestimmen, wenn die jeweilige Spannung unterhalb der Halbwellenspannung liegt, so dass das Problem der nicht-eindeutigen Spannungsbestimmung keine Rolle spielt.

Die Temperaturkorrektur erfolgt gemäss Gleichung (5) bzw. (6) mit der nach (8) ermittelten Temperaturab-

weichung $\Delta T$. Dank dieser Massnahme sind die elektro-optischen Koeffizienten genauer bekannt, so dass der Spannungswert $V$ mit grösserer Genauigkeit und Zuverlässigkeit ermittelt werden kann.

Es ist ebenfalls möglich, das in (8) beschriebene Kompensationsverfahren auf den Fall paralleler Polarisatoren gemäss Gleichung (1) zu übertragen, wobei sich das Gleichungssystem (7) und die Formeln für $e$ und $f$ in Gleichung (8) entsprechend ändern.

Das Kompensationsverfahren lässt sich auch auf Fälle verallgemeinern, bei welchen die Temperaturabhängigkeit des elektro-optischen Koeffizienten nicht linear ist, wie in Gleichung (6). Dies kann insbesondere in der Nähe eines Phasenübergangs eines elektro-optischen Mediums der Fall sein. In diesem Fall sind in Gleichungssystem (7) die entsprechenden Funktionen $r(T)$ einzusetzen. Nötigenfalls muss die Lösung von Gleichungssystem (7) sodann numerisch bestimmt werden.

Der Literatur sind Werte für $r(T)$ entnehmbar sowie Methoden zur Bestimmung solcher Werte. Beispielsweise in K.S.Lee et al., "Optical, Thermo-optic, Electrooptic and Photo-elastic Properties of Bismuth Germanate ($Bi_4Ge_3O_{12}$)", National Bureau of Standards, USA 1988, sind entsprechende Angaben für einen BGO-Kristall für verschiedene Wellenlängen zu finden. Ebenda sind auch Werte für die Temperaturabhängigkeit von $n^3r$ gegeben. Dieser kombinierte elektro-optische Term $n^3r$ wird im folgenden als $R$ bezeichnet:

$$R = n^3 r \tag{10}$$

Da, wie in Gleichung (2) angegeben, die Halbwellenspannung $V_h$ von $R$ abhängt und somit auch $A_i$ von $R$ abhängt, kann statt $r(T)$ auch $R(T)$ zur Temperaturkompensation benutzt werden. Auf diese Weise ist eine noch bessere Temperatur-Kompensation erreichbar. Die Temperaturabhängigkeit von $r$ ist im allgemeinen deutlich stärker als die von $n$ (siehe z.B. die genannte Veröffentlichung von K.S.Lee et al.), so dass eine Vernachlässigung der Temperaturabhängigkeit von $n$, welche oben gemacht wurde, eine gute Näherung an die vollständige Kompensation mittels $R(T)$ darstellt.

Für die vollständige Kompensation ergeben sich in Analogie zu den obigen Gleichungen unmittelbar die folgenden Formeln, wobei diese Formeln jeweils diejenigen Gleichungen ersetzen, welche dieselbe Gleichungsnummer ungestrichen haben:

$$R = R(T) = n^3(T) \cdot r(T) \tag{3'}$$

$$R(\lambda_i, T) = R(\lambda_i, T_0) + K_i \cdot \Delta T \tag{6'}$$

$K_i$ (ungestrichen) ist somit der Proportionalitätskoeffizient für eine lineare Temperaturabhängigkeit des kombinierten elektro-optischen Terms $R = n^3r$.

$$\begin{aligned} A_1(V,T) &= \frac{A_{0,1}}{2} \cdot \left[ 1 - \cos\left( 2\pi \cdot \frac{R^3(\lambda_1, T_0) + K_1 \cdot \Delta T}{\lambda_1} \cdot V \right) \right] \\ A_2(V,T) &= \frac{A_{0,2}}{2} \cdot \left[ 1 - \cos\left( 2\pi \cdot \frac{R^3(\lambda_2, T_0) + K_2 \cdot \Delta T}{\lambda_2} \cdot V \right) \right] \end{aligned} \tag{7'}$$

Bestimmung der Temperaturabweichung:

$$\Delta T = \frac{af - ce}{de - bf} \; mit$$
$$a = 2\pi \cdot R^3(\lambda_1, T_0)/\lambda_1$$
$$b = 2\pi \cdot K_1/\lambda_1$$
$$c = 2\pi \cdot R^3(\lambda_2, T_0)/\lambda_2 \qquad (8')$$
$$d = 2\pi \cdot K_2/\lambda_2$$
$$e = \arccos\left(1 - \frac{2A_1}{A_{0,1}}\right)$$
$$f = \arccos\left(1 - \frac{2A_2}{A_{0,2}}\right)$$

Bestimmung der Spannung:

$$V = \arccos\left(1 - \frac{2 \cdot A_i}{A_{0,i}}\right) \cdot \frac{\lambda_i}{2\pi \cdot \left(R^3(\lambda_i, T_0) + K_i \cdot \Delta T\right)} \qquad (9')$$

Für die Durchführung der Erfindung mit der vollständigen Kompensation mittels $R(T)$ statt $r(T)$ gilt ansonsten dasselbe wie im Falle des weiter oben beschriebenen Vorgehens mit $r(T)$. Dies gilt selbstverständlich auch für die Übertragbarkeit der Gleichungen auf den Fall, dass Polarisator 9 und Analysator 10 parallel zueinander ausgerichtet sind.

In den obigen Beispielen wird als elektro-optisches Medium ein BGO-Kristall verwendet, wobei das Feld in $z$-Richtung angelegt wird und das Licht sich in $z$-Richtung ausbreitet. Es ist auch möglich, andere Geometrien und andere elektro-optische Medien zu verwenden, wie z.B. Kristalle aus $LiNbO_3$ oder BSO oder nichtzentrisch polarisierte Polymere.

Die hier beschriebenen Techniken-sind ferner auch auf Medien anwendbar, bei denen der elektro-optische Effekt nicht linear (Pockels-Effekt) sondern quadratisch (Kerr-Effekt) auftritt, wobei insbesondere die Gleichungen (1), (1'), (1*), (5), (7), (7'), (8), (8'), (9) und (9') entsprechend anzupassen sind. So ist z.B. in Gleichung (1') der Sinus von einem Quadrat der angelegten Spannung zu berechnen.

<u>Bezugszeichenliste</u>

| | |
|---|---|
| 1: | BGO-Kristall |
| 2,3: | Elektroden |
| 4: | Erdpotential-Anschluss |
| 5: | Hochspannungspotential-Anschluss |
| 6: | Umlenkprisma |
| 7,8: | Kollimatoren |
| 9: | Polarisator |
| 10: | Analysator |
| 11,12: | eingekoppelte und ausgekoppelte Lichtstrahlen |
| 13: | Lichterzeugungseinheit |
| 14: | Strahlteiler |
| 15: | Detektions-Auswerte-Einheit |

| | |
|---|---|
| 16: | Auswertemittel |
| $A_0,i$: | Signalamplituden |
| *a, b, c, d, e, f*: | Koeffizienten |
| *K*: | Temperaturkoeffizient |
| *n*: | Brechungsindex |
| *r*: | elektro-optischer Koeffizient |
| *R*: | kombinierter elektro-optischer Term ($R=n^3r$) |
| *T*: | Temperatur |
| $\Delta T$: | Temperaturabweichung |
| *V*: | Spannung |
| $V_h$: | Halbwellenspannung |
| $\lambda_1, \lambda_2$: | Wellenlängen der eingekoppelten Strahlen |

## Patentansprüche

**1.** Verfahren zur Messung einer elektrischen Spannung *V* mit einem elektro-optischen Medium (1), wobei das elektro-optische Medium (1) einem von der Spannung V abhängigen elektrischen Feld ausgesetzt wird und mindestens zwei polarisierte Lichtstrahlen (11) unterschiedlicher Wellenlänge (λ1, λ2) in das elektro-optische Medium (1) eingestrahlt werden, und wobei Ausgangssignale Al und *A*2 der Lichtstrahlen gemessen werden, wobei *A*1**-** und *A*2 temperaturabhängige Funktionen *f*1 und *f*2 der Spannung *V* sind, und wobei diejenigen Werte der Temperatur *T* und der Spannung *V* gesucht werden, die das Gleichungssystem

$$A1 = f1(T, V) \qquad \text{und} \qquad A2 = f2\,(T, V)$$

lösen,
**dadurch gekennzeichnet,**
**dass** die mindestens zwei polarisierten Lichtstrahlen (11) nach Durchlaufen des elektro-optischen Mediums (1) analysiert werden,
**dass** die Spannungsabhängigkeit der Brechungsindex-Änderung durch einen effektiven elektro-optischen Koeffizienten *r* oder einen kombinierten elektro-optischen Term *R* mit $R = n^3r$ beschrieben wird, wobei *n* der Brechnungsindex des Mediums (1) ist,
**dass** für den effektiven elektro-optischen Koeffizienten *r* oder den kombinierten elektro-optischen Term *R* eine bekannte Temperaturabhängigkeit $r = r(T)$ oder $R = R(T)$ vorausgesetzt wird,
**dass** die bekannte Temperaturabhängigkeit $r = r(T)$ des effektiven elektro-optischen Koeffizienten *r* oder $R = R(T)$ des kombinierten elektro-optischen Terms *R* in das Gleichungssystem eingesetzt wird und **dadurch** die Temperatur *T* und die Spannung *V* berechnet wird, und
**dass** die Funktionen *f*1 und *f*2 in nicht-eindeutiger Weise von der Spannung *V* abhängen und dass diejenige Spannung *V* ermittelt wird, für welche beide-Gleichungen des Gleichungssystems erfüllt sind.

**2.** Verfahren nach einem der vorangehenden Ansprüche, **dadurch gekennzeichnet, dass** eine spannungsinduzierte Brechungsindex-Änderung im Medium (1) über den Pockels-Effekt vom elektrischen Feld abhängt.

**3.** Verfahren nach Anspruch 2, **dadurch gekennzeichnet, dass** für den effektiven elektro-optischen Koeffizienten *r* oder für den kombinierten elektro-optischen Term *R* eine lineare Temperaturabhängigkeit

$$r(\lambda_i,T) = r(\lambda_i,T_0) + K_i{}'\cdot\Delta T \qquad \text{mit } \Delta T = T - T_0$$

oder

$$R(\lambda_i,T) = R(\lambda_i,T_0) + K_i\cdot\Delta T \qquad \text{mit } \Delta T = T - T_0$$

mit bekannter Grösse $r(T_0)$ oder $R(T_0)$ bei einer Referenztemperatur $T_0$ und mit bekannten Proportionalitätskoeffizienten $K_i'$ oder $K_i$ vorausgesetzt wird, wobei der Index i=1,2 für die unterschiedliclzen Wellenlängen ($\lambda_1, \lambda_2$) indiziert.

4. Verfahren nach einem der vorangehenden Ansprüche, **dadurch gekennzeichnet, dass** das elektro-optische Medium (1) ein Kristall, insbesondere ein BGO-Kristall ist.

5. Vorrichtung zur Messung einer elektrischen Spannung V umfassend

- ein elektro-optisches Medium **(1),** welches einem von der Spannung *V* abhängigen elektrischen Feld aussetzbar ist,
- eine Lichterzeugungseinheit (13) zur Erzeugung von mindestens zwei Lichtstrahlen (11) unterschiedlicher Wellenlängen ($\lambda_1$, $\lambda_2$)
- einen Polarisator (9), und
- eine Detektions-Auswerte-Einheit (15) zur Erfassung von Ausgangssignalen $A_1$ und $A_2$ der Lichtstrahlen (12), wobei $A_1$ und $A_2$ temperaturabhängige Funktionen $f_1$ und $f_2$ der Spannung V sind,

wobei

- die Lichterzeugungseinheit (13), der Polarisator (9) und das elektro-optische Medium (1) derart miteinander optisch verbunden sind, dass mindestens zwei polarisierte Lichtstrahlen (11) unterschiedlicher Wellenlängen ($\lambda_1$, $\lambda_2$) in das elektro-optische Medium (1) einkoppelbar sind, und
- die Detektions-Auswerte-Einheit (15) ein Auswertemittel (16) beinhaltet zur Bestimmung derjenigen Werte der Temperatur *T* und der Spannung *V*, die Lösungen des Gleichungssystems $A_1 = f_1(T, V)$ und $A_2 - f_2(T, V)$ sind,

**dadurch gekennzeichnet,**

- **dass** die Vorrichtung einen Analysator (10) umfasst,
- **dass** das elektro-optische Medium (1), der Analysator (10) und die Detektions-Auswerte-Einheit **(15)** derart miteinander optisch verbunden sind, dass die mindestens zwei polarisierten Lichtstrahlen (12) aus dem elektro-optischen Medium (1) auskoppelbar und in die Detektions-Auswerte-Einheit (15) einkoppelbar sind, so dass die mindestens zwei polarisierten Lichtstrahlen (12) in dem Analysator (10) analysierbar sind,
- **dass** zur Bestimmung der Lösung des Gleichungssystems in der Auswerte-Einheit (15) die Spannungsabhängigkeit der Brechungsindex-Änderung durch einen effektiven elektro-optischen Koeffizienten *r* oder einen kombinierten elektro-optischen Term *R* mit $R = \boldsymbol{n^3 r}$ beschrieben ist, wobei *n* der Brechnungsindex des Mediums (1) ist, und wobei für den effektiven elektro-optischen Koeffizienten *r* oder für den kombinierten elektro-optischen Term *R* eine bekannte Temperaturabhängigkeit $r = r(T)$ oder $R = R(T)$ vorausgesetzt ist, und
- **dass** die Funktionen $\boldsymbol{f_1}$ und $f_2$ in nicht-eindeutiger Weise von der Spannung *V* abhängig sind und dass mittels des Auswertemittels (16) diejenige Spannung *V* ermittelbar ist, für welche beide Gleichungen des Gleichungssystems erfüllt sind.

6. Vorrichtung zur Messung einer elektrischen Spannung *V* gemäss Anspruch 5, **dadurch gekennzeichnet, dass** das elektro-optische Medium (1) eine über den Pockels-Effekt vom elektrischen Feld abhängige spannungsinduzierte Brechungsindex-Änderung aufweist.

## Claims

1. A method for measuring an electric voltage V with an electro-optical medium (1), wherein the electro-optical medium (1) is subjected to an electric field that is dependent on the voltage V and at least two polarized light beams (11) of different wavelengths (λ1, λ2) are emitted into the electro-optical medium (1), wherein output signals A1 and A2 of the light beams are measured, wherein A1 and A2 are temperature-dependent functions f1 and f2 of the voltage V, and wherein those values of the temperature T and the voltage V are determined that solve the equation system A1 = f1(T, V) and A2 = f2(T, V),
**characterized in**
**that** the at least two polarized light beams (11) are analyzed after passing through the electro-optical medium (1), in **that** the dependence of the change in the refractive index on the voltage is described in the form of an effective electro-optical coefficient r or a combined electro-optical term R with $R = n^3r$, wherein n is the refractive index of the medium (1), in
**that** the effective electro-optical coefficient r or the combined electro-optical term R is assumed to have a known temperature dependence r = r(T) or R = R(T), respectively, in
**that** the known temperature dependence r = r(T) of the effective electro-optical coefficient r or R = R(T) of the

combined electro-optical term R is inserted into the equation system in order to calculate the temperature T and the voltage V, and in
**that** the functions f1 and f2 are in a non-unique way dependent on the voltage V and the determined voltage V fulfills both equations of the equation system.

**2.** The method according to one of the preceding claims, **characterized in that** a voltage-induced change in the refractive index of the medium (1) is dependent on the electric field as a function of the Pockels effect.

**3.** The method according to Claim 2, **characterized in that** the effective electro-optical coefficient r or the combined electro-optical term R is assumed to have a linear temperature dependence

$$r(\lambda_1, T) = r(\lambda_1, T_0) + K_i' \times \Delta T, \qquad \text{with } \Delta T = T - T_0$$

or

$$R(\lambda_1, T) = R(\lambda_1, T_0) + K_1 \times \Delta T, \qquad \text{with } \Delta T = T - T_0$$

with a known variable $r(T_0)$ or $R(T_0)$ at a reference temperature $T_0$ and with known proportionality coefficients $K_1'$ or $K_1$, wherein the index i = 1, 2 is indicative of the different wavelengths ($\lambda_1$, $\lambda_2$).

**4.** The method according to one of the preceding claims, **characterized in that** the electro-optical medium (1) consists of a crystal, particularly a BGO-crystal.

**5.** A device for measuring an electric voltage V, comprising

- an electro-optical medium (1) that can be subjected to an electric field that is dependent on the voltage V,
- a light generating unit (13) for generating at least two light beams (11) of different wavelengths ($\lambda_1$, $\lambda_2$),
- a polarizer (9), and
- a detection-evaluation unit (15) for acquiring output signals $A_1$ and $A_2$ of the light beams (12), with $A_1$ and $A_2$ representing temperature-dependent functions $f_1$ and $f_2$ of the voltage V,

wherein

- the light generating unit (13), the polarizer (9) and the electro-optical medium (1) are optically connected to one another in such a way that at least two polarized light beams (11) of different wavelengths ($\lambda_1$, $\lambda_2$) can be coupled into the electro-optical medium (1), and
- the detection-evaluation unit (15) contains an evaluation means (16) for determining those values of the temperature T and the voltage V that solve the equation system $A_1 = f_1(T, V)$ and $A_2 = f_2(T, V)$,

**characterized in**

- **that** the device comprises an analyzer (10), in
- **that** the electro-optical medium (1), the analyzer (10) and the detection-evaluation unit (15) are optically connected to one another in such a way that the at least two polarized light beams (12) can be decoupled from the electro-optical medium (1) and coupled into the detection-evaluation unit (15) in order to analyze the at least two polarized light beams (12) in the analyzer (10), in
- **that** the dependence of the change in the refractive index on the voltage is described in the form of an effective electro-optical coefficient r or a combined electro-optical term R with $R = n^3 r$ in order to determine the solution of the equation system in the evaluation unit (15), wherein n is the refractive index of the medium (1), and wherein the effective electro-optical coefficient r or the combined electro-optical term R is assumed to have a known temperature dependence r = r(T) or R = R(T), respectively, and in
- **that** the functions $f_1$ and $f_2$ are in a non-unique way dependent on the voltage V, wherein the evaluation means

(16) is used for determining the voltage V that fulfills both equations of the equation system.

6. The device for measuring an electric voltage V according to Claim 5, **characterized in that** a voltage-induced change in the refractive index of the electro-optical medium (1) is dependent on the electric field as a function of the Pockels effect.

**Revendications**

1. Procédé pour la mesure d'une tension V électrique avec un fluide (1) électro-optique, le fluide (1) électro-optique étant exposé à un champ électrique dépendant de la tension (8) et au moins deux faisceaux lumineux (11) polarisés de longueur d'onde ($\lambda_1$, $\lambda_2$) différente étant injectés dans le fluide (1) électro-optique, et des signaux de sortie A1 et A2 des faisceaux lumineux étant mesurés, A1 et A2 étant des fonctions f1 et f2, dépendantes de la température, de la tension V, et les valeurs de la température T de la tension V étant recherchées, lesquelles résolvent le système d'équations A1 = f1 (T, V) et A2 = (T, V),
**caractérisé en ce que**,
les au moins deux faisceaux lumineux (11) polarisés sont analysés après la traversée du fluide (1) électro-optique,
**en ce que** la dépendance vis-à-vis de la tension de la variation de l'indice de réfraction est décrite par un coefficient r électro-optique effectif ou un terme R électro-optique combiné avec $R = n^3r$, n étant l'indice de réfraction du fluide (1),
**en ce que**, pour le coefficient r électro-optique effectif ou le terme R électro-optique combiné, on suppose une dépendance vis-à-vis de la température connue r = r(T) ou R = R(T),
**en ce que** la dépendance connue vis-à-vis de la température r = r(T) du coefficient électro-optique effectif r ou R = R(T) du terme électro-optique combiné est insérée dans le système d'équations et de ce fait la température T et la tension V sont calculées, et
**en ce que** les fonctions f1 et f2 dépendent de façon non univalente de la tension V et que la tension V est calculée, pour laquelle les deux équations du système d'équations sont satisfaites.

2. Procédé selon l'une quelconque des revendications précédentes, **caractérisé en ce qu'**une variation de l'indice de réfraction induite par tension dans le fluide (1) par rapport à l'effet de Pockels dépend du champ électrique.

3. Procédé selon la revendication 2, **caractérisé en ce que**, pour le coefficient r électro-optique effectif ou pour le terme R électro-optique combiné, on suppose une dépendance linéaire vis-à-vis de la température

$$r(\lambda_1, T) = r(\lambda_1 - T_0) + K'_1 \cdot \Delta T \qquad \text{avec } \Delta T = T - T_0$$

ou

$$R(\lambda_1, T) = R(\lambda_1 - T_0) + K_1 \cdot \Delta T \qquad \text{avec } \Delta T = T - T_0$$

avec la grandeur connue $r(T_0)$ ou $R(T_0)$ pour une température de référence $T_0$ et avec des coefficients de proportionnalité $K'_i$ ou $K_i$ connus, l'indice i = 1, 2 étant indiqué pour les longueurs d'onde ($\lambda_1$, $\lambda_2$) différentes.

4. Procédé selon l'une quelconque des revendications précédentes, **caractérisé en ce que** le fluide (1) électro-optique est un cristal, en particulier un cristal de BGO.

5. Dispositif pour la mesure d'une tension V électrique comprenant

- un fluide (1) électro-optique, qui est exposé à un champ électrique dépendant de la tension V,
- une unité de production de lumière (13) pour la production d'au moins deux faisceaux lumineux (11) de longueurs d'onde ($\lambda_1$, $\lambda_2$) différentes
- un polarisateur (9), et
- une unité d'analyse de détection (15) pour l'enregistrement des signaux de sortie $A_1$ et $A_2$ des faisceaux lumineux (12), $A_1$ et $A_2$ étant des fonctions $f_1$ et $f_2$, dépendantes de la température, de la tension V,

moyennant quoi

- l'unité de production de lumière (13), le polarisateur (9) et le fluide (1) électro-optique sont reliés optiquement entre eux de telle sorte qu'au moins deux faisceaux lumineux (11) polarisés de longueurs d'onde ($\lambda_1$, $\lambda_2$) différentes sont injectés dans le fluide (1) électro-optique, et
- l'unité d'analyse de détection (15) contient un moyen d'analyse (16) pour la détermination des valeurs de la température T et de la tension V, qui sont des solutions du système d'équations $A_1 = f_1(T, V)$ et $A_2 = f_2$ (T, V),

**caractérisé**

- **en ce que** le dispositif comprend un analyseur (10),
- **en ce que** le fluide (1) électro-optique, l'analyseur (10) et l'unité d'analyse de détection (15) sont reliés entre eux optiquement de telle sorte que les au moins deux faisceaux lumineux (12) peuvent être dissociés du fluide (1) électro-optique et peuvent être injectés dans l'unité d'analyse de détection (15), de sorte que les au moins deux faisceaux lumineux (12) polarisés peuvent être analysés dans l'analyseur (10),
- **en ce que**, pour la détermination de la solution du système d'équations dans l'unité d'analyse (15), la dépendance vis-à-vis de la tension de la variation de l'indice de réfraction est décrite par un coefficient r électro-optique effectif ou un terme R électro-optique combiné avec $R = n^3r$, n étant l'indice de réfraction du fluide (1), et moyennant quoi, pour le coefficient r électro-optique effectif ou pour le terme R électro-optique combiné, on suppose une dépendance connue vis-à-vis de la température r = r(T) ou R = R(T), et
- **en ce que** les fonctions $f_1$ et $f_2$ sont dépendantes de façon non univalente de la tension V et en ce que, au moyen de l'unité d'analyse (16), on peut déterminer la tension V pour laquelle les deux équations du système d'équations sont satisfaites.

**6.** Dispositif pour la mesure d'une tension V électrique selon la revendication 5, **caractérisé en ce que** le fluide (1) électro-optique présente une variation de l'indice de réfraction induite par tension et dépendante du champ électrique par l'effet de Pockels.

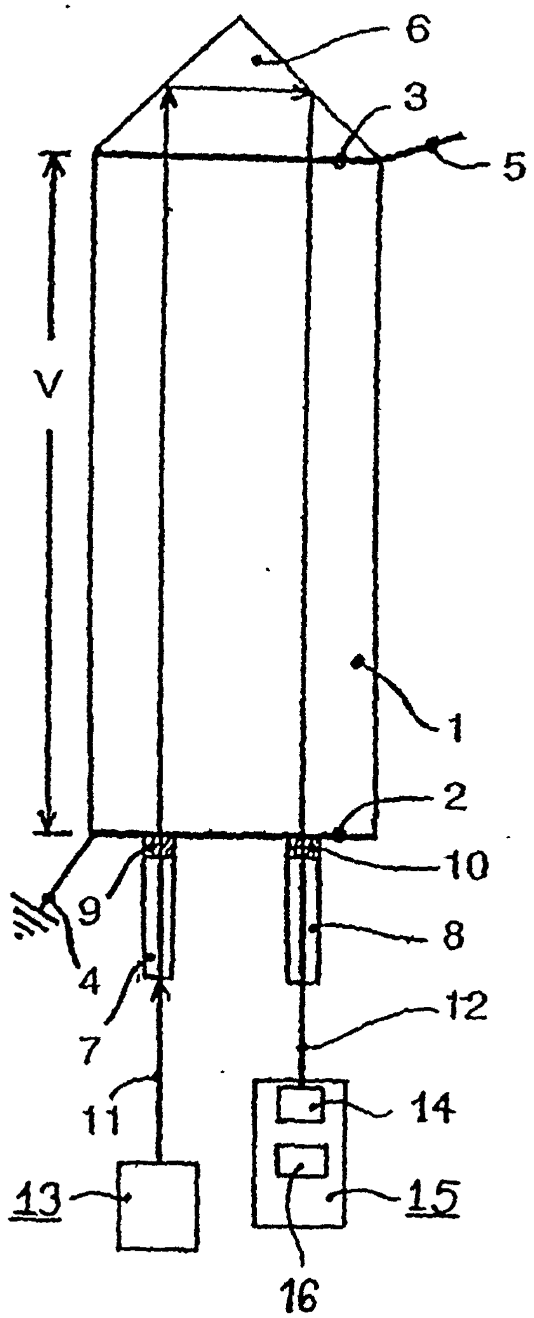


Fig. 1